Europäisches Patentamt

European Patent Office

Office européen des brevets

(11) Publication number: **0 076 856**
A1

# EUROPEAN PATENT APPLICATION

published in accordance with Art. 158(3) EPC

(21) Application number: 81900955.6

(22) Date of filing: 21.04.81

Data of the international appli-
cation taken as a basis:

(86) International application number:
PCT/JP 81/00093

(87) International publication number:
WO 82/03727 (28.10.82 82/26)

(51) Int. Cl.³: **H 01 L 21/28**, H 01 L 23/28

(43) Date of publication of application: 20.04.83
Bulletin 83/16

(84) Designated Contracting States: CH DE FR LI

(71) Applicant: AIGOO, Seiichiro, 15-13, Negishi 3-chome
Taito-ku, Tokyo 110 (JP)

(72) Inventor: AIGOO, Seiichiro, 15-13, Negishi 3-chome
Taito-ku, Tokyo 110 (JP)

(74) Representative: Chameroy, Claude et al, c/o Cabinet
Malemont 42, avenue du Président Wilson, F-75116 Paris
(FR)

(54) **METHOD OF MAKING A SEMICONDUCTOR DEVICE HAVING A PROJECTING, PLATED ELECTRODE.**

(57) An insulating layer (26), with an opening corresponding to the position where projecting electrode is to be provided, is formed onto a semiconductor wafer having aluminum wiring layers (25) thereon. A metal layer (27) is formed thereon as a ground coating for electroplating and then a photoresist layer with a corresponding opening is applied as a mask, which makes it possible to next provide a metal plating as a projecting electrode (29) which metal is available for wire-bonding. The projecting electrode (29) is formed by removing unnecessary portions of the ground coating layer (27) for plating and the photoresist layer without the position for providing the projecting electrode. The electrode is composed of a plurality of layers (25), (27) and (29), that provide a good seal to the surface of a chip (32). In addition, the chip (32) is provided with glass-passivation (35) and molded in plastic (36) after a wire (31) is bonded, so that the seal is even more effective. Further, a lift-off method may be used to remove the plating ground coating layer (27).

DESCRIPTION

Method of Manufacturing Semiconductor Device
with Plated Bump

## TECHNICAL FIELD

This invention relates to a resin-molded semiconductor device used for electric circuits, and more particularly a semiconductor device with plated bumps having a sealing structure which can prevent an external environment atmosphere from invading through the contact surfaces with a resin mold at the lead drawing out portions for drawing out leads from active and passive elements in a semiconductor chip to the exterior.

## BACKGROUND ART

In the field of a semiconductor device, according to a well known prior method for drawing out leads from active and passive elements in a semiconductor chip to the exterior, aluminium is first evaporated on the surface of the chip to form internal wiring and bonding regions. The leads such as a wire are bonded to a lead frame or a circuit substrate by ultrasonic bonding, thermo compression bonding or other techniques and then a resin mold is formed around the chip, so that the semiconductor device is completed.

More specifically, when manufacturing a DIP type resin-molded semiconductor device as shown in Fig.1, an oxide film 4 is formed on a semiconductor chip 1 with a cellector region 2 and a base region 3, and an aluminium layer 5 is applied thereon/to form internal wiring and bonding regions, as shown in Figs.3 and 4. Then, a passivation film 6 is coated to protect the overall surface except for the bonding regions, the aluminium layer 5 serving as bonding pads is connected to a lead frame 8 or a circuit substrate using a drawing out lead such as a wire 7, and a resin mold 9 is formed around the chip to obtain the complete semiconductor device.

In thus arranged semiconductor device, however, the aluminium bonding pad 5 to which the drawing out lead such as the wire 7 is connected has size of 80 ~ 150 $\mu$m square, while the wire 7 has a thichness of 25 ~ 30 $\mu$m in diameter. Therefore, the semiconductor device is sealed by the resin mold 9 in the state such that the aluminium surface of the pad is exposed at positions other than the connected poriton of the wire 7 to the aluminium bonding pad 5. In this manner, even if the lead frame 8, wire 7 and semiconductor chip 1 have been sealed by the resin mold 9, there will appear gaps with age at the sealing contact surface with the resin depending on environmental conditions such as temperature, moisture or various gases, to which the semiconductor device will be subjected, thereby unabling to achive the completely sealed state. When moisture or various gases enter along the lead frame 8 and wire 7 from those gaps and reach to the aluminium bonding pad 5, purple plague phenomenon will occur in the bonding bad where the aluminium surface is exposed, and this may causes breaking of the semiconductor device. Furthermore, another drawback has been also experienced such that although the surface of the semiconductor chip 1 is protected by the passivation film 6, for example an oxide film, phospherous glass film or nitride film, the film itself is very thin and of tenly includes pinholes therein, whereby moisture or gas having entered through those gaps causes insulation breakdown on the surface of the semiconductor chip other than the

-4-

bonding pad.

It is an object of this invention  to provide a method of manufacturing a semiconductor device in which such purple plague phenomenon or insulation breakdown will not occur and which can be handled with ease.

DISCLOSURE OF INVENTION

A method of manufacturing a semiconductor device with plated bumps according to this  invention comprises a first process in which an insulation film with openings at bump formed positions is applied on a semiconductor wafer having aluminium wiring thereon, a second process in which a plating ground metal layer is formed on the insulation film, a third process in which a photo regist layer with openings at bump formed positions is masked over the plating ground metal layer, a fourth process in which an easily bonded metal with drawing out leads such as a wire is plated at bump formed positoions on the plating ground metal layer to form bumps, a fifth process in which the photo regist layer and the plating ground metal layer locating at those positions other than  bump formed positions are removed to complete a semiconductor chip, a sixth process in which the semiconductor chip is bonded to a lead frame or a circuit substrate, a seventh process in which the drawing out leads such as a wire are bonded to the bumps on the semiconductor chip to complete a semiconductor bump chip, and a eighth process in which the semiconductor bump chip is passivation-treated using passivation glass. In the semiconductor device made by the manufacturing method according to this invention, the bumps to be led out to the exterior for energizing are fully covered with the plating ground metal on the surface which includes the aluminium wiring, so that purple plague phenomenon will not occur. Also even when an easily oxdizable metal is used for the plating ground metal, conduction breakdown will not occur because of passivation treatment and further insulation breakdown will not occur due to the passivation-treated surface of the semiconductor chip. Furthermore, in the prior semiconductor chip with plated bumps when handled or dealed, wire loops after being bonded were prone to contact with each other, make edge touching or cause twist failure due to bad connection with the lead frame, instability of resin mold techinque applied

-6-

after loading the chip on the circuit substrate comprising thin and thick films, and failure of the resin mold itself, while in the manufacturing method of this invention, the passivation treatment is carried out after wire bonding, so that reduction in yield can be avoided irrespective of instablity of the resin mold and semiconductor devices with high reliability can be obtained.

In addition, this invention may include a ninth process prior to the second process mentioned above, in which a photo regist layer with openings at bump formed positions is masked over the foregoing insulation film. In this case, the plating ground metal layer to be applied in the second process is formed on the photo regist layer masked in the ninth process.

BRIEF DESCRIPTION OF DRAWINGS

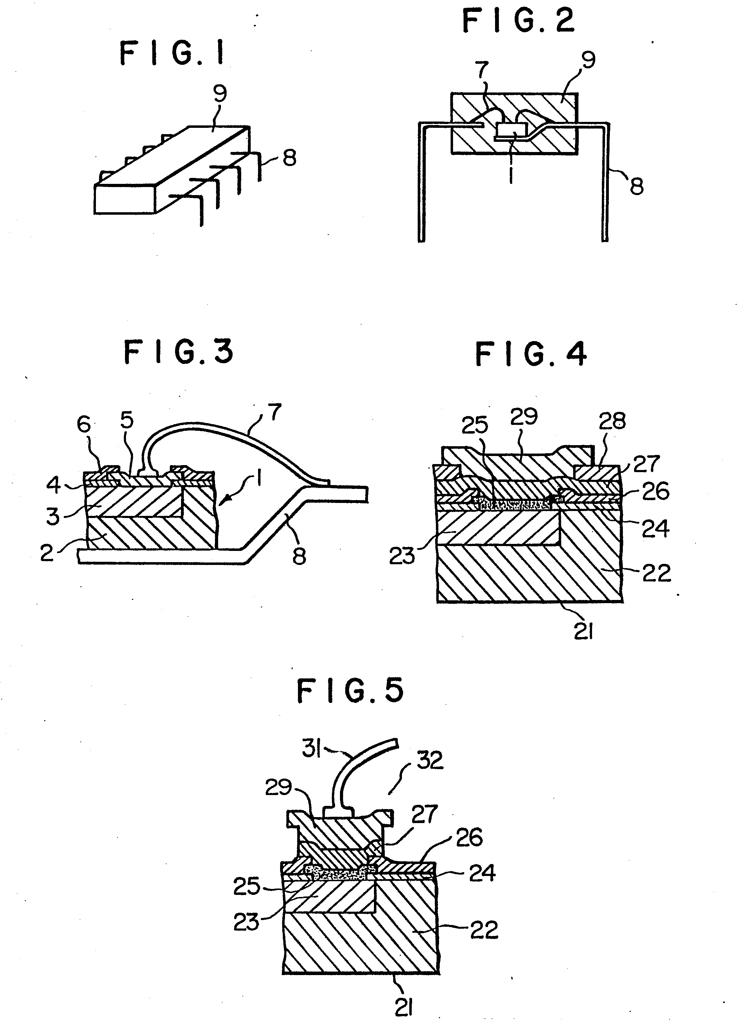

Fig.1 is a perspective view of a completed mold type semiconductor device, Fig.2 is a sectional explanatory view of the prior mold type semiconductor device, Fig.3 is a partially enlarged view of the mold type semiconductor device shown in Fig.2, and Figs.4 ～ 7 are views showing processes of a manufacturing method according to this invention; in which Fig.4

-7-

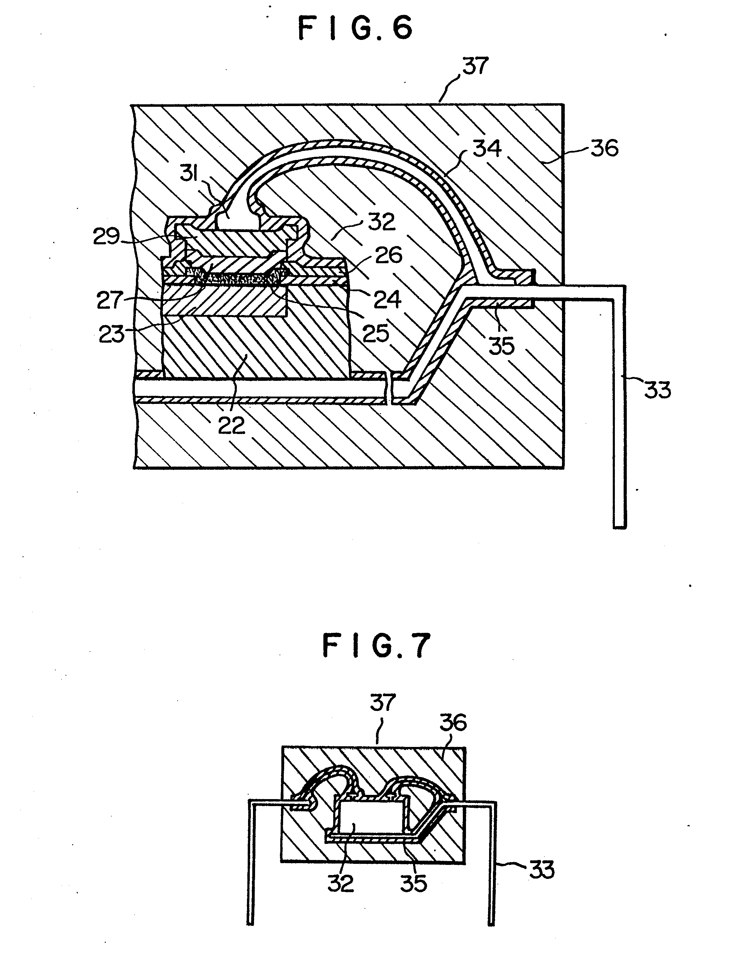

is a partial sectional view of a semiconductor chip in the state where bump plating has finished, Fig.5 is a partial sectional view of a semiconductor bump chip in the state where wire bonding has finished, Fig.6 is a partial sectional view of the completed semidonductor device, and Fig.7 is a sectional view showing the whole of the completed semiconductor device.

BEST MODE FOR CARRYING OUT THE INVENTION

To describe in more detail, this inveniton will be explained with reference to the accompanying drawings hereinafter.

According to / the present method for manufacturing a semiconductor device with plated bumps, as shown in Figs.4,5,6 and 7, in a semiconductor chip 21 having not only a collector region 22 and a base region 23 but also an oxide film 24 and an aluminium layer 25 functioning as wiring and located at bump formed positions, an insulation layer 26 is applied on the aluminium layer 25 by vapor growth, evaporation, sputtering or other suitable techniques. That insulation film 26 comprises silicon oxide ($SiO_2$), for example, and has a thickness of $2\mu \sim 3\mu$. After

-8-

applying the insulation film 26, the film 26 is photoetched to make openings at bump formed positions.

Then, a plating ground metal layer 27 is applied over the aluminium layer 25 and insulation film 26.
As a plating ground metal, it is /required to use such metals as producing a strong adhesion force with the aluminium layer 25 and insulation film 26, having relatively small oxide generation energy, and being easily bonded to the bump forming plated layer mentioned later. Chromium (Cr), copper (Cu) or gold (Au) can be used as the plating ground metal meeting such conditions. The plating ground metal layer 27 is applied all over the wafer surface, so that the layer 27 constitutes bonding pads together with the bump forming plated layer. The plating ground metal layer 27 is applied by evaporation or sputtering and has a thickness 5000 Å ~ 8000 Å depending on the grades of completed devices.

Then, to allow partial bump plating, a photo regist 28 is coated on the plating ground metal layer 27 in a thickness of about $2\mu$ and opeings are made at bump formed positions in the photo regist 28 by pattern treatment.

Then, a bump forming plated layer 29 is applied

-9-

at bump formed positions.  The bump plating is carried out utilizing non-cyanic gold plating bath on the market, but other materials may be substituld for non-cyanic gold.  Thickness of the plated layer locates in a range of $5\mu \sim 25\mu$ and is optionable depending cn the purpose of completed semiconductor devices.  When using non-cyanic gold plating bath on the market, about 4 minutes is required for developing the plated layer of $1\mu$ in the normal plating velocity and typical current density in such condition is 4 $mA/cm^2$.  Fig.4 shows the semiconductor chip in the state where the forgoing processes have finished.

Then, the photo regist 28 coated for bump plating is lifted off and the rest of the plating ground layer 27 is also removed while leaving only the layer 27 located at bump formed positions necessary for the aluminium layer 25 and bump forming plated layer 29 to be closely bonded to the insulation film 26 and energized.  Thereafter, a wire 31 is connected to the bump forming plated layer 29.  At the end of this process, a semiconductor chip 32 as shown in Fig.5 is completed.

Then, after bonding the semiconductor chip 32 to a lead frame 33, the semiconductor chip 32 is electrically connected with the lead frame 33 through the wire 31 for energizing, so that a semiconductor bump chip 34 is completed.

Then, for the purpose of passivation, passivation glass is vaporized by vacuum evaporation, vacuum sputtering or laser beam sputtering and then depositted over the semiconductor bump chip 34 so as to form a deposition film 35. Thickness of the deposition film is suitable in a range of 5000 Å ~ 50000 Å and optionable depending on the varieties of semiconductor devices.

Finally, the whole chip is molded by sealing resin to form a resin molded layer 36, so that a semiconductor device with plated bumps 37 is completed. Fig.6 and 7 show the DIP type resin molded semiconductor device with plated beumps which has been manufactured in such a manner.

In addition, when utiliting a regist lifting off method, the chip is pattern-treated by using the photo regist coat identical to the foregoing photoregist 28 after forming the insulation film 26 and prior to applying the plating ground metal layer 27 as mentioned above.

Besides, although the wire 31 is used as the drawing out leads in the above description by way of example, the wire 31 may be replaced by other different type leads such as a drawing out lead formed by etching or punching.

INDUSTRIAL APPLICABILITY

As described in the above, the semiconductor device with plated bumps made by the manufacturing method according to this invention has positive sealing function and thus can be effectively used for electric circuits that will be subjected to inferior environment containing moisture or harmful gas.

0076856

-12-

WHAT IS CLAIMED IS :

(1) A method of manufacturing a semiconductor device with plated bumps comprsing a first process in which an insulation film with openings at bump formed positions is applied on a semiconductor wafer having aluminium wiring thereon, a second process in which a plating ground metal layer is formed on said insulation film, a third process in which a photo regist layer with openings at bump formed positions is masked over said plating ground metal layer, a fourth process in which an easily bonded metal with drawing out leads such as a wire is plated at bump formed positions on said plating ground metal layer to form bumps, a fifth process in which said photo regist layer and said plating ground metal layer locating at those positions other than bump formed positions are removed to complete a semiconductor chip, a sixth process in which said semiconductor chip is bonded to a lead frame or a circuit substrate, a seventh process in which the drawing out leads such as a wire are bonded to said bumps on said semiconductor chip to complete a semiconductor bump chip, and a eighth process in which said semiconductor bump chip is passivation-treated using passivation glass.

(2) A method of manufacturing a semiconductor device with plated bumps according to Claim 1, including prior to said second process a ninth process in which a photo regist layer with openings at bump formed positions is masked over said insulation film, and wherein said plating ground metal layer to be applied in said second process is formed on said photo regist layer masked in said ninth process.

0076856

FIG.1

FIG.2

FIG.3

FIG.4

FIG.5

FIG.6

FIG.7

# INTERNATIONAL SEARCH REPORT

International Application No    PCT/JP81/00093

| | |
|---|---|
| **I. CLASSIFICATION OF SUBJECT MATTER** (if several classification symbols apply, indicate all) 3 | |

According to International Patent Classification (IPC) or to both National Classification and IPC

Int. Cl.$^3$   H01L21/28, H01L23/28

## II. FIELDS SEARCHED

| Minimum Documentation Searched 4 | |
|---|---|
| Classification System | Classification Symbols |
| I P C | H01L21/28, H01L21/44, H01L23/28 <br> H01L29/40, H01L21/92, H01L21/60 |

Documentation Searched other than Minimum Documentation
to the Extent that such Documents are Included in the Fields Searched 5

Jitsuyo Shinan Koho      1960 - 1982

## III. DOCUMENTS CONSIDERED TO BE RELEVANT 14

| Category * | Citation of Document, 16 with indication, where appropriate, of the relevant passages 17 | Relevant to Claim No. 18 |
|---|---|---|
| X | JP, A, 54-159865     1979-12-18 <br> Page 1, lower left column, line 1 to page 2, upper left column, line 9 <br> FUJITSU LIMITED | 1 - 2 |
| X | JP, A, 52-70763,     1977-6-13 <br> Page 1 and Fig. 1 <br> TOSHIBA CORPORATION | 1 - 2 |
| X | DE, A, 2618026,     1976-11-4 <br> Page 3, line 24 to page 6, line 8, <br> Figs. 1 to 3 <br> NCRCorp | 1 - 2 |
| X | JP, B1, 48-40664,     1973-12-1 <br> Page 1, Column 2, lines 3 to 15 <br> Hitachi, Ltd. | 1 - 2 |

* Special categories of cited documents: 15

"A" document defining the general state of the art

"E" earlier document but published on or after the international filing date

"L" document cited for special reason other than those referred to in the other categories

"O" document referring to an oral disclosure, use, exhibition or other means

"P" document published prior to the international filing date but on or after the priority date claimed

"T" later document published on or after the international filing date or priority date and not in conflict with the application, but cited to understand the principle or theory underlying the invention

"X" document of particular relevance

## IV. CERTIFICATION

| Date of the Actual Completion of the International Search 2 | Date of Mailing of this International Search Report 2 |
|---|---|
| July 8, 1981 (08.07.81) | July 20, 1981 (20.07.81) |
| International Searching Authority 1 | Signature of Authorized Officer 20 |
| Japanese Patent Office | |

Form PCT/ISA/210 (second sheet) (October 1977)